# EUROPÄISCHE PATENTSCHRIFT

(11) **EP 0 467 151 B1**
(45) Veröffentlichungstag und Bekanntmachung des Hinweises auf die Patenterteilung: **30.03.1994**
(21) Anmeldenummer: 91111035.1
(22) Anmeldetag: 03.07.1991
(51) Int. Cl.: B60H 1/00, H05K 7/20

(54) **Kraftfahrzeug mit einer elektrischen Steuerung mit wärmeabgebenden Bauelementen**
Vehicle with an electric controller having heat dissipating components
Véhicule pourvu d'une commande électrique dont les composants dégagent de la chaleur

(30) Priorität: 20.07.1990 DE 4023146
(43) Veröffentlichungstag der Anmeldung: 22.01.1992
(73) Patentinhaber: STILL GMBH, D-22113 Hamburg (DE)
(72) Erfinder: Kröhling, Erich, Dipl.-Ing. (FH), W-2057 Reinbek (DE); Muth, Wolf-Dietrich, Dipl.-Ing., W-2093 Stelle (DE)
(74) Vertreter: Schaefer, Gerhard, Dr.

(56) Entgegenhaltungen:
- DE-A- 3 331 890
- DE-A- 3 443 311
- GB-A- 2 199 203

## Beschreibung

Die Erfindung betrifft ein Kraftfahrzeug mit einer elektrischen Steuerung mit wärmeabgebenden Bauelementen.

Die DE-A-33 31 890 zeigt ein Kraftfahrzeug, bei dem wärmeabgebende Bauelemente einer Steuerung eines Lüftermotors auf einer Lüftungsklappe einer Kraftfahrzeugheizung oder -klimaanlage angeordnet sind. Die Lüftungsklappe wird durch den Luftstrom des Lüftermotors gekühlt.

Die elektronischen Bauelemente befinden sich bei der Kraftfahrzeugheizung unabhängig von der Stellung der Lüftungsklappe immer innerhalb eines Lüftungsgehäuses, in dem auch der Wärmetauscher angeordnet ist. Sofern sich die Lüftungsklappe in einer Stellung befindet, in der ein Bypass-Kanal geöffnet und der Luftzutritt zum Wärmetauscher geschlossen ist, werden die elektronischen Bauelemente durch den vom Lüfter erzeugten Luftstrom direkt gekühlt, indem der Luftstrom auf diejenige Seite der Lüftungsklappe auftrifft und vorbeistreicht, auf der die elektronischen Bauelemente befestigt sind. Im Falle, daß sich die Lüftungsklappe in einer Stellung befindet, in der der Bypass-Kanal geschlossen ist, wird die Rückseite der Lüftungsklappe gekühlt.

Analog dazu erfolgt bei der Kraftfahrzeugklimaanlage in der einen Stellung der Lüftungsklappe eine unmittelbare Kühlung der elektronischen Bauelemente durch einen direkt auftreffenden und vorbeistreichenden Luftstrom und in der anderen Stellung der Lüftungsklappe eine mittelbare Kühlung der Bauelemente durch Vorbeistreichen des Luftstroms an der Rückseite der Lüftungsklappe.

In beiden Fällen sind die elektronischen Bauelemente frei auf der Lüftungsklappe angeordnet. Es muß daher dafür Sorge getragen werden, daß die angesaugte Luft frei von Feuchtigkeit und von Staub und Schmutz ist, was eine Filterung des Luftstroms erforderlich macht. Darüber hinaus erzwingt diese Art der Kühlung von elektronischen Bauelementen, nämlich durch Anordnung auf einer von einem Luftstrom umspülten Lüftungsklappe, ein Gebläse zur Erzeugung eines wärmeabführenden Luftstromes, da die Lüftungsklappe innerhalb eines für die Wärmeabgabe ungeeigneten Kunststoffgehäuses ohne Kontakt zu wärmeabführenden Teilen, wie Rahmen und/oder Aufbau des Kraftfahrzeugs angeordnet ist. Die Lüftungsklappe ist daher für sich genommen aufgrund Ihrer kleinen Fläche, ihrer geringen Masse und der Anordnung innerhalb eines Gehäuses, also eines Einbauteils ohne Flächenkontakt zu wärmeabführenden Fahrzeugteilen, ohne Zwangsluftführung durch ein Gebläse für die Wärmeabfuhr von elektronischen Baulementen größerer Leistung nicht geeignet.

Aus der nicht gattungsgemäßen GB-A-2 199 203 ist ein Frequenzumformer bekannt, bei dem wärmeabgebende elektronische Bauelemente in einer gekapselten Baugruppe angeordnet sind, die in einer mit Kühlwasser gefüllten Kammer am unteren Ende des Frequenzumformers angeordnet ist. Die Baugruppe befindet sich dabei in der Mitte der Kammer und ist ringsum vollständig von Kühlwasser umgeben. Die Kapselung der wärmeabgebenden Bauelemente ist durch die Anordnung in Kühlwasser bedingt. Andernfalls käme es zum Kurzschluß.

Bei Kraftfahrzeugen mit elektrischem Fahrantrieb erfolgt die Steuerung mit Hilfe von Leistungshalbleitern. Elektrische Fahrantriebe sind sowohl für Elektrostraßenfahrzeuge (PKW, Transporter, Busse) als auch für innerbetriebliche Transportfahrzeuge bekannt. So werden Elektro-Flurförderzeuge in der Regel zur Steuerung von Fahr-, Hydraulik- und Lenkhilfsmotoren mit elektronischen Thyristor- oder Transistorsteuerungen ausgerüstet. Die in diesen Halbleiterbauelementen in Wärme umgewandelte Verlustleistung muß an die Umgebung abgeführt werden. Üblicherweise werden die wärmeerzeugenden Leistungshalbleiter auf Kühlkörper montiert, welche Rippen aufweisen und durch die Umgebungsluft gekühlt werden. Falls die Raumverhältnisse es zulassen, können die Kühlkörper unmittelbar auf massereiche Rahmenteile montiert werden, so daß eine ausreichende Wärmeabfuhr gewährleistet ist.

Aus Platzgründen und um eine gute Zugänglichkeit für Wartungsarbeiten zu ermöglichen, kann es notwendig werden, die Steuerung an einem Einbauort anzuordnen, an dem keine ausreichend massereichen Rahmenteile zur Wärmeabfuhr zur Verfügung stehen, beispielsweise am Rahmen-Seitenblech neben der Traktionsbatterie. Hier ist das Wärmeabfuhrvermögen begrenzt.

Dies führt dazu, daß in bestimmten Einsatzfällen, in denen das Fahrzeug durch häufiges Anfahren und Steigungsfahrt besonders hoch beansprucht wird, eine zusätzliche direkte Luftkühleinrichtung vorgesehen werden muß, bei der die Kühlung der wärmeabführenden Bauelemente durch ein Gebläse erfolgt. Wenn zusätzlich die Forderung besteht, die Steuerung gegen Wasser und Staub zu schützen, müssen die wärmeabgebenden Bauelemente in einem Gehäuse untergebracht werden, das mit der Luftkühleinrichtung in Verbindung steht, wobei dann die Luftkühleinrichtung mit einem Filter ausgerüstet werden muß, der regelmäßig zu reinigen bzw. auszutauschen ist, was betriebliche Nachteile und Kosten verursacht.

Wegen des hohen Aufwandes einer Kühleinrichtung wird eine solche daher vorzugsweise nur dann eingesetzt, wenn die Verwendung des Fahrzeugs dies erforderlich macht. Je nach dem geplanten Einsatzbereich des Fahrzeugs werden also zwei Fahrzeugtypen benötigt, nämlich ein Fahrzeug mit Gebläsekühlung und ein Fahrzeug ohne Gebläsekühlung der Steuerung. Es ist deshalb leicht einzusehen, daß der Fahrzeughersteller bestrebt sein wird, eine Grundversion zur Verfügung zu stellen, die leicht mit dem Gebläse nachrüstbar ist. Andererseits soll die Grundversion des Fahrzeugs möglichst wenig durch die für den Lüfteranbau vorzusehenden Teile in den Kosten beeinflußt werden, was jedoch in der Praxis große Schwierigkeiten bereitet.

Der vorliegenden Erfindung liegt die Aufgabe zugrunde, mit einfachen Mitteln ein Kraftfahrzeug der eingangs genannten Art zur Verfügung zu stellen, das sowohl eine wasser- und staubgeschützte Steuerung aufweist als auch eine leichte Nachrüstbarkeit der Steuerung mit einem Kühlgebläse ermöglicht.

Diese Aufgabe wird erfindungsgemäß dadurch gelöst, daß die Steuerung für einen elektrischen Fahrantrieb und/oder elektrischen Hilfsantrieb vorgesehen ist und die Bauelemente wasser- und staubgeschützt in einem geschlossenen Gehäuse angeordnet sind, das mit mindestens einer wärmeabgebenden Außenseite mit einem für die Wärmeaufnahme geeigneten Teil des Kraftfahrzeugs flächig in Kontakt steht, wobei die Kontaktfläche durch mindestens einen Luftführungskanal zwischen der Außenseite des Gehäuses und dem Kraftfahrzeug unterbrochen ist und an den Luftführungskanal ein Gebläse anschließbar ist. Der erfindungswesentliche Gedanke besteht also darin, die wärmeabgebenden Leistungshalbleiter, die einen wesentlichen Teil der Steuerung bilden, in einem wasser- und staubdichten Gehäuse von der Umgebung abzukapseln und dieses Gehäuse zwecks Wärmeabfuhr mit einem dafür geeigneten Teil des Kraftfahrzeuges flächig zu verbinden, wobei gegebenenfalls eine Steigerung der Wärmeabfuhr durch Kühlung des betreffenden Teils und/oder des Gehäuses mittels eines Gebläses erfolgen kann, das die genannten Teile von außen mit Kühlluft beaufschlagt. Hierbei wird dann sowohl die Steuerung als auch der Teil des Kraftfahrzeuges, auf dem die Steuerung befestigt ist, gleichzeitig durch das Gebläse gekühlt. Dadurch wird eine kostengünstige Grundausführung mit gekapselter Steuerung und Abfuhr der Verlustwärme an den Fahrzeugrahmen ermöglicht. Für harten Fahrzeugeinsatz ist die einfache Zurüstmöglichkeit einer Belüftungseinrichtung gegeben, ohne die vollkommene Kapselung aufheben zu müssen. Zu diesem Zweck wird der Luftstrom über eine äußere Kühlfläche der Steuerung und/oder des Teiles, auf dem die Steuerung befestigt ist, geführt, so daß kein Schmutz in die Steuerung eindringen kann und sich eine Filterung der Kühlluft erübrigt.

Es erweist sich hinsichtlich einer kostengünstigen und dennoch gut wärmeableitenden Ausführung des Gehäuses als günstig, wenn dieses aus einer Metallwanne und einem damit verbundenen, eine Lippendichtung aufweisenden Deckel besteht. Darüber hinaus ermöglicht ein solcherart aufgebautes Gehäuse einen sicheren Schutz vor Staub und Spritzwasser.

Um die Wärmeabfuhr von den wärmeabgebenden Bauelementen weiter zu verbessern, sind zweckmäßigerweise auf der Innenseite der Metallwanne Kühlkörper befestigt, auf denen die wärmeabgebenden Bauelemente angeordnet sind und ist auf der Außenseite der Metallwanne ein Kühlblech vorgesehen, wodurch die Wärme auf eine möglichst große Fläche verteilt wird. Besonders einfach und kostengünstig kann der bzw. können die Luftführungskanäle durch eine Mehrzahl von voneinander beabstandeten Kontaktblechen gebildet werden, die mit dem Kraftfahrzeug und dem Gehäuse flächig in Verbindung stehen. Der Kühleffekt kann noch verbessert werden, wenn gemäß einer vorteilhaften Weiterbildung des Erfindungsgegenstandes die im Wärmefluß zwischen den wärmeabgebenden Bauelementen und dem Kraftfahrzeug liegenden Bauteile aus einem gut wärmeleitenden Material bestehen, beispielsweise aus Aluminium oder Kupfer.

Die Vorteile der Erfindung kommen besonders bei Elektro-Flurförderzeugen mit einer Leistungshalbleiter aufweisenden elektronischen Steuerung der Fahr-, Hydraulik- und Lenkhilfsmotoren zur Geltung, da hier in verstärktem Maße sehr unterschiedliche Einsatzbedingungen gegeben sind, so daß Geräteausführungen mit und ohne Gebläsekühlung benötigt werden.

Die Erfindung soll anhand der nachstehend beschriebenen schematischen Figuren in einem Ausführungsbeispiel näher erläutert werden.

Es zeigen:

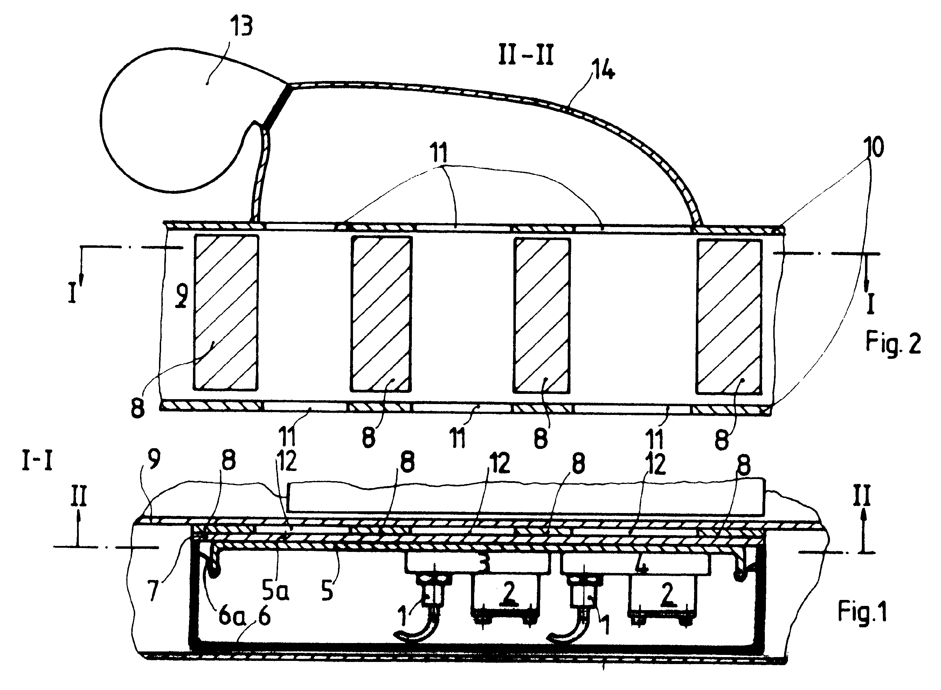

- Figur 1: einen Horizontalschnitt durch den Seitenbereich eines Elektro-Flurförderzeuges (entsprechend Linie I - I in Figur 2),
- Figur 2: einen Vertikalschnitt durch den Seitenbereich eines Elektro-Flurförderzeuges gemäß Linie II - II in Figur 1.

In den Figuren ist ein kastenförmiger Längsholm eines Elektro-Flurförderzeuges dargestellt, in dessen Innerem eine Impulssteuerung für die Fahrmotoren bzw. Hydraulik- und Lenkhilfsmotoren angeordnet ist. Die Impulssteuerung weist wärmeabgebende Bauelemente 1, 2 auf, die auf Kühlkörpern 3, 4 befestigt und in eine Metallwanne 5 eingebaut sind. Die Metallwanne 5 ist mit einem Deckel 6 über eine Lippendichtung 6a dicht verschlossen und bildet ein gekapseltes Gehäuse. Die Verlustwärme der Impulssteuerung wird über die Kühlkörper 3, 4, die Metallwanne 5 und ein Kühlblech 7, das auf der Außenseite 5a der Metallwanne 5 befestigt ist und zur Verteilung der Wärme auf eine möglichst große Fläche dient, sowie z.B. vier Kontaktbleche 8 auf eine Rahmenseitenwand 9 eines Fahrzeugrahmens 10 des Elektro-Flurförderzeuges übertragen. Die Kühlkörper 3, 4, das Kühlblech 7 und die Kontaktbleche 8 bestehen vorzugsweise aus einem gut wärmeleitenden Material, z.B. Kupfer oder Aluminium. Bereits in der Grundausrüstung ist der Fahrzeugrahmen 10 oberhalb und unterhalb der Impulssteuerung mit Rahmenschlitzen 11 versehen, die in Verbindung mit dem Bereich zwischen den Kontaktblechen 8 Luftführungskanäle 12 bilden und es ermöglichen, die Impulssteuerung bei Bedarf zu hinterlüften.

Hierzu wird ein Gebläse 13, vorzugsweise ein Radialgebläse, über der Impulssteuerung angebracht, das einen Luftstrom über ein Luftführungsteil 14 durch die Rahmenschlitze 11 und die zwischen den Kontaktblechen 8 verbleibenden Luftführungskanäle 12 treibt. Dadurch wird sowohl die Rahmenseitenwand 9 als auch das Kühlblech 7 großflächig gekühlt. Da sich die Luftführung außerhalb des Gehäuses der Impulssteuerung befindet, ist eine Filterung der Kühlluft überflüssig.

## Patentansprüche

1. Kraftfahrzeug mit einer elektrischen Steuerung mit wärmeabgebenden Bauelementen (1,2), **dadurch gekennzeichnet**, daß die Steuerung für einen elektrischen Fahrantrieb und/oder elektrischen Hilfsantrieb vorgesehen ist und die Bauelemente (1, 2) wasser- und staubgeschützt in einem geschlossenen Gehäuse (5, 6, 6a) angeordnet sind, das mit mindestens einer wärmeabgebenden Außenseite (5a) mit einem für die Wärmeaufnahme geeigneten Teil des Kraftfahrzeugs flächig in Kontakt steht, wobei die Kontaktfläche durch mindestens einen Luftführungskanal (12) zwischen der Außenseite (5a) des Gehäuses (5, 6, 6a) und dem Kraftfahrzeug unterbrochen ist und an den Luftführungskanal (12) ein Gebläse (13) anschließbar ist.

2. Kraftfahrzeug nach Anspruch 1, dadurch gekennzeichnet, daß das Gehäuse (5, 6, 6a) aus einer Metallwanne (5) und einem damit verbundenen, eine Lippendichtung (6a) aufweisenden Deckel (6) besteht.

3. Kraftfahrzeug nach Anspruch 2, dadurch gekennzeichnet, daß auf der Innenseite der Metallwanne (5) Kühlkörper (3, 4) befestigt sind, auf denen die wärmeabgebenden Bauelemente (1, 2) angeordnet sind, und daß auf der Außenseite (5a) der Metallwanne (5) ein Kühlblech (7) vorgesehen ist.

4. Kraftfahrzeug nach einem der Ansprüche 1 bis 3, dadurch gekennzeichnet, daß zur Bildung des Luftführungskanals (12 eine Mehrzahl von voneinander beabstandeten Kontaktblechen (8) vorgesehen ist, die mit dem Kraftfahrzeug und dem Gehäuse flächig in Verbindung stehen.

## Claims

1. A motor vehicle with an electric control unit with heat-emitting components (1, 2), characterised in that the control unit is provided for an electric travelling drive mechanism and/or electric auxiliary drive mechanism and the components (1, 2) are arranged, protected from water and dust, in a closed housing (5, 6, 6a) which, with at least one heat-emitting outer side (5a), is in surface contact with a part of the motor vehicle suitable for the absorption of heat, where the contact surface is interrupted by at least one air circulation channel (12) between the outer side (5a) of the housing (5, 6, 6a) and the motor vehicle and a fan (13) can be connected to the air circulation channel (12).

2. A motor vehicle as claimed in Claim 1, characterised in that the housing (5, 6, 6a) consists of a metal trough (5) and a cover (6) which is connected to the metal trough and comprises a lip seal (6a).

3. A motor vehicle as claimed in Claim 2, characterised in that cooling bodies (3, 4), on which the heat-emitting components (1, 2) are arranged, are attached on the inside of the metal trough (5), and a cooling plate (7) is provided on the outer side (5a) of the metal trough (5).

4. A motor vehicle as claimed in one of Claims 1 to 3, characterised in that for the formation of the air circulation channel (12) a plurality of contact plates (8) are provided which are spaced from one another and are superficially connected to the motor vehicle and to the housing.

## Revendications

1. Véhicule automobile équipé d'une commande électrique comprenant des éléments (1, 2) dégageant de la chaleur, caractérisé en ce que la commande est prévue pour commander un appareillage électrique de roulement et/ou des équipements électriques auxiliaires, ses éléments (1, 2) sont disposés à l'abri de l'eau et de la poussière à l'intérieur d'un boîtier fermé (5, 6, 6a) qui se trouve en contact par la surface d'au moins une face externe (5a) émettrice de la chaleur avec une partie réceptrice du véhicule, cette surface de contact étant interrompue par au moins un canal de ventilation (12) situé entre la face externe (5a) du boîtier (5, 6, 6a) et le véhicule et auquel peut être raccordé une soufflante (13).

2. Véhicule automobile selon la revendication 1, caractérisé en ce que le boîtier (5, 6, 6a) est constitué d'un carter métallique (5) fermé par un couvercle (6) équipé d'un joint d'étanchéité à lèvre (6a).

3. Véhicule selon la revendication 2, caractérisé en ce que sur la face interne du carter métallique (5) sont fixés des blocs de refroidissement (3, 4) sur lesquels sont montés les éléments (1, 2) émetteurs de chaleur, tandis qu'une tôle de refroidissement (7) est montée sur la face externe (5a) du carter métallique (5).

4. Véhicule automobile selon l'une des revendications 1 à 3, caractérisé en ce que les canaux de ventilation (12) sont conçus en disposant plusieurs tôles de contact (8), espacées les unes des autres et reliées par leurs surfaces au véhicule et au boîtier.
